# EUROPEAN PATENT SPECIFICATION

(11) **EP 2 542 043 B1**
(45) Date of publication and mention of the grant of the patent: **23.12.2015**
(21) Application number: 10848975.8
(22) Date of filing: 27.05.2010
(51) Int. Cl.: H05K 9/00, H01B 11/10

(54) **COMPOSITE FOR ELECTROMAGNETIC SHIELDING**
VERBUNDSTOFF FÜR EINE ELEKTROMAGNETISCHE ABSCHIRMUNG
COMPOSITE POUR BLINDAGE ÉLECTROMAGNÉTIQUE

(30) Priority: 30.03.2010 JP 2010077162
(43) Date of publication of application: 02.01.2013
(73) Proprietor: JX Nippon Mining & Metals Corporation, Tokyo 100-8164 (JP)
(72) Inventor: KAMMURI Kazuki, Hitachi-shi Ibaraki 317-0056 (JP); MURATA Masateru, Hitachi-shi Ibaraki 317-0056 (JP)
(74) Representative: Prüfer & Partner GbR European Patent Attorneys
(86) International application number: PCT/JP2010/058975
(87) International publication number: WO 2011/121801

(56) References cited:
- WO-A1-2004/016060
- JP-A- 2 097 097
- JP-A- H1 140 980
- JP-A- 2004 060 018
- JP-A- 2004 256 832
- JP-A- 2005 248 221
- JP-A- 2005 344 207
- JP-A- 2006 324 546
- JP-A- 2007 146 258
- JP-A- 2008 166 655
- JP-A- 2010 006 071
- US-A- 4 749 625
- US-A- 5 573 857

## Description

### Field of the Invention

The present invention relates to an electromagnetic shielding composite comprising a copper foil and a resin film laminated thereon.

### Description of the Related Art

A copper foil composite comprising a copper foil and a resin film laminated thereon is used as an electromagnetic shielding material (see Patent Literature 1). The copper foil has an electromagnetic shielding property, and the resin film is laminated thereon to reinforce the copper foil. For example, the resin film is laminated on the copper foil using an adhesive agent, or copper is vapor deposited on the surface of the resin film. In order to ensure the electromagnetic shielding property, the copper foil should have a thickness of several micrometers or more. Accordingly, laminating the resin film on the copper foil is inexpensive.

Meanwhile, the surface of the copper foil is oxidized and corroded by external environments such as salt water and heat, whereby the shielding property is deteriorated as the time elapsed. In order to avoid this, a metal thin film comprising tin, nickel or chrome is formed on the surface of the copper foil having no resin film laminated(see Patent Literature 2).

[Patent Literature 1] Japanese Unexamined Patent Publication (Kokai) Hei7-290449
[Patent Literature 2] Japanese Unexamined Patent Publication (Kokal) Hei2-97097

### Problems to be solved by the Invention

When the surface of the copper foil is plated with Sn or Ni, the ductility of the copper foil is decreased, and the durability to bending and cyclic bend is degraded, which may result in easy cracking. Once the copper foil is cracked, the shielding property is degraded. In addition, Sn continues to diffuse even at several tens of Celsius degree. Also, in a high temperature environment and after a long period of use, an Sn-Cu alloy layer is produced on the surface of the copper foil. The Sn-Cu alloy layer is brittle, so that the ductility of the copper foil is degraded as the time elapsed and the copper foil is then easily cracked. Furthermore, since Sn has low heat resistance, not only the ductility of the copper foil is degraded, but also contact resistance with a drain wire is increased to be unstable after a long period of use in a high temperature environment. Thus, the shielding property is degraded.

Thus, an object of the present invention is to provide an electromagnetic shielding composite such that the copper foil is protected from cracking caused by bending and cyclic bend, and the shielding property is not easily deteriorated as the time elapsed.

### Summary of the Invention

The present inventors found that a copper foil is prevented from cracking by coating one surface of the copper foil with a predetermined coating amount of Ni, and forming a Cr oxide layer thereon. The object of the present invention is achieved by the electromagnetic shielding composite according to claims 1 and 2, which preferred embodiments as set forth in the dependent claims.

In one embodiment, the present invention provides an electromagnetic shielding composite, comprising a copper foil having a thickness of 5 to 15 µm, a Ni coating on one surface of the copper foil at a coating amount of 90 to 5000 µg/dm², a Cr oxide layer formed on the surface of the Ni coating at 5 to 100 µg/dm² based on the Cr mass, and a resin layer laminated on the opposite surface of the copper foil. And, the copper foil has elongation after fracture of 5% or more, and (F x T) / (f x t) => 1 is satisfied where t is the thickness of the copper foil, f is a stress of the copper foil at tensile strain of 4%, T is the thickness of the resin layer, and F is a stress of the resin layer at tensile strain of 4%.

In another embodiment, the present invention provides an electromagnetic shielding composite, comprising a copper foil having a thickness of 5 to 15 µm, Ni coatings on both surfaces of the copper foil at a coating amount of 90 to 5000 µg/dm² respectively, Cr oxide layers formed on the surfaces of the Ni coatings at 5 to 100 µg/dm² based on the Cr mass, and a resin layer laminated on one surface of the Cr oxide layer on the copper foil. And, the copper foil has elongation after fracture of 5% or more, and (F x T) / (f x t) => 1 is satisfied where t is the thickness of the copper foil, f is a stress of the copper foil at tensile strain of 4%, T is the thickness of the resin layer, and F is a stress of the resin layer at tensile strain of 4%.

Preferably, (R₂ - R₁)/R₁<0.5 is satisfied where R₁ is the electric resistance of the electromagnetic shielding composite having a length of 50 mm at 20°C and R₂ is the electric resistance of the electromagnetic shielding composite having a length of 50 mm at 20°C after 15% tensile deformation is applied at room temperature.

Preferably, (R₃ - R₁)/R₁<0.5 is satisfied where R₁ is the electric resistance of the electromagnetic shielding composite having a length of 50 mm at 20°C and R₃ is the electric resistance of the electromagnetic shielding composite having a length of 50 mm at 20°C after heating at 80°C for 1000 hours and 15% tensile deformation is applied at room temperature.

Preferably, the copper foil contains Sn and/or Ag at a total content of 200 to 2000 mass ppm.

### Effect of the Invention

According to the present invention, an electromagnetic shielding composite can be obtained such that the copper foil is protected from cracking caused by bending and cyclic bend, and the shielding property is not easily deteriorated as the time elapsed.

### Description of the Preferred Embodiments

The electromagnetic shielding composite according to the present invention comprises a copper foil, a Ni coating on one surface of the copper foil, a Cr oxide layer formed on the surface of the Ni coating, and a resin film laminated on the other side of the copper foil.

### <Copper foil>

The thickness of the copper foil is 5 to 15 µm. When the thickness of the copper foil is less than 5 µm, the copper foil itself has a decreased electromagnetic shielding effect, and is easily cracked. That is, the copper foil may be cracked by simple bending of an electric wire or a cable, and the shielding property may be significantly degraded. When the thickness of the copper foil exceeds 15 µm, the electromagnetic shielding composite is difficult to be wound around the electrical wire or the cable due to the stiffness of the copper foil.

Since the shielding property is improved by using the copper foil having the conductivity of IACS of 60% or more, the copper foil has preferably high purity of, preferably 99.5% or more, more preferably 99.8% or more. Preferably, the copper foil may be a rolled copper foil having an excellent bending property, or an electro-deposited copper foil.

The copper foil may contain other elements, so long as a total content of these elements and inevitable impurities is less than 0.5 wt %. In particular, when the copper foil contains Sn and/or Ag at a total content of 200 to 2000 mass ppm, heat resistance can be improved and elongation is also improved as compared with those of a pure copper foil having the same thickness.

### <Resin layer>

The resin layer is not especially limited. The copper foil may be coated with a resin material for forming the resin layer. A resin film which can be adhered to the copper foil is preferable. Examples of the resin film include a polyethylene terephthalate (PET) film, a polyethylene naphtalate (PEN) film, a polyimide (PI) film, a liquid crystal polymer (LCP) film and a polypropylene (PP) film. In particular, the PET film is preferably used.

The resin film may be laminated on the copper foil by using an adhesive agent between the resin film and the copper foil, or thermally compressing the resin film to the copper foil without using the adhesive agent. Through the viewpoint of adding no extra heat to the resin film, the adhesive agent is preferably used. The thickness of the adhesive agent layer is preferably 6 µm or less. When the thickness of the adhesive agent layer exceeds 6 µm, only the copper foil is easily broken after the copper foil composite is laminated. Examples of the adhesive agent include an epoxy-based, polyimide-based, urethane-based or vinyl chloride-based adhesive agent. A softening agent (elastomer) may be contained therein. An adhesive strength is preferably 0.4 kN/m or more.

Preferably, the electromagnetic shielding composite is tailored to satisfy (F x T) / (f x t) => 1, where t is the thickness of the copper foil, f is a stress of the copper foil at tensile strain of 4%, T is the thickness of the resin layer, and F is a stress of the resin layer at tensile strain of 4%, whereby the ductility becomes high and the bending property is improved.

The reason cannot be not clearly explained. Each of (F x T) and (f x t) represents a stress per unit width (e.g., (N/mm)), and the copper foil and the resin layer are laminated to have the same width. That is, (F x T)/(f x t) represent a ratio of the force applied to the copper foil and the resin layer constituting the copper foil composite. Therefore, when the ratio is 1 or more, the resin layer is stronger than the copper foil. Then, the copper foil is easily affected by the resin layer, and since the copper foil extends uniformly, it is considered that the ductility of the whole copper foil composite becomes high.

In fact, an annealed copper round bar material has elongation after fracture (elongation) of about 100%. However, once the material is worked into the foil, since the foil constricts in a thickness direction and broken immediately, only several % of elongation is shown. On the other hand, the resin film such as PET is difficult to constrict under tension (has a wide uniform elongation area).

Accordingly, in the composite of the copper foil and the resin layer, deformation behavior of the resin is transmitted to the copper foil such that the copper foil is deformed just the same as the resin. As a result, the copper foil has the wide uniform elongation area (is difficult to constrict).

Because of this, when F and T of the resin layer are set to satisfy the above-mentioned relationship to balance the strength of the copper foil, the elongation of the composite can be improved, and the copper foil is prevented from cracking due to the deformation such as bending and cyclic bending.

In the present invention, when the composite is strained, only the copper foil may be broken or the composite (comprising the copper foil and the resin layer) may be broken at the same time. When only the copper foil is broken, the point which the copper foil is broken is defined as fracture of the composite. When the copper foil and the resin layer of the composite are broken at the same time, the point which these are broken is defined as fracture of the copper foil and the resin layer.

The thickness T of the resin layer is not especially limited, but is generally about 7 to 25 µm. If the thickness T is less than 7 µm, the value of (F x T) is decreased, (F x T) / (f x t) => 1 is not satisfied, and elongation after fracture (elongation) of the electromagnetic shielding composite tends to be decreased. On the other hand, if the thickness T exceeds 25 µm, the stiffness of the resin may be increased excessively, and the electromagnetic shielding composite tends to be difficult to be wound around the electric wire or the cable.

In the case that the resin layer and the adhesive agent layer can be distinguished and separated, the F and T of "the resin layer" according to the present invention refer to the values of the resin layer excluding the adhesive agent layer. In the case that the resin layer and the adhesive agent layer cannot be distinguished, only the copper foil is dissolved from the copper foil composite, and "the resin layer" including the adhesive agent layer may be measured. This is because the resin layer is generally thicker than the adhesive agent layer, the values of the F and T are not so different from those of only the resin layer, even if the adhesive agent layer is included in the resin layer.

Herein, the F and f may be the stresses at the same strain amount after the plastic deformation. In view of the elongation after fracture of the copper foil and the strain at which the plastic deformation of the resin layer (for example, the PET film) is started, the stress is obtained at tensile strain of 4%. The f can be measured by a tensile test of the copper foil remained after the resin layer is removed from the copper foil composite with a solvent. Similarly, the F can be measured by a tensile test of the resin layer remained after the copper foil is removed from the copper foil composite with an acid and so on. When the copper foil and the resin layer are laminated via the adhesive agent, upon the measurement of the F and the f, by removing the adhesive agent layer with a solvent, the copper foil and the resin layer are peeled to conduct separately the tensile test of the copper foil and the resin layer. The T and t can be measured by observing a section of the copper foil composite with a variety of microscopes (such as an optical microscope).

If the values of the f and F of the copper foil and the resin layer are known before the copper foil composite is produced, and if the heat treatment such that the properties of the copper foil and the resin layer are greatly changed upon the production of the copper foil composite is not performed, the known values of the f and F before the production of the copper foil composite may be used.

Preferably, the resin layer has the F of 100 MPa or more and the elongation after fracture of 20% or more, and more preferably the elongation after fracture is 80% or more. The upper limit of the elongation after fracture is not especially limited. The resin layer has preferably the greater elongation after fracture. However, when the elongation after fracture is greater, the resin layer tends to have the decreased strength. It is therefore desirable that the resin layer has the elongation after fracture of 130% or less. As described above, the elongation after fracture of the copper foil is smaller than the elongation after fracture of the resin layer, and the elongation of the copper foil is improved by the resin layer. When the value of the F is uniform, the greater the elongation after fracture (elongation) of the resin, the greater the elongation after fracture (elongation) of the composite comprising the resin layer and the copper foil(the better the elongation of the composite).

If the F of the resin layer is less than 100 MPa, the resin layer has decreased strength, the resultant composite has no effect to improve the elongation of the copper foil, and it is difficult to prevent crack(s) in the copper foil. On the other hand, the upper limit of the F of the resin layer may not be especially limited. The resin layer has preferably the greater F. However, when the resin layer has the high F (strength) and thickness T, the composite may be difficult to be wound around the cable. In this case, the thickness T is adjusted to be thin.

Examples of the resin layer include a biaxially-oriented PET film which is strongly drawn.

In general, increasing the stress of the resin more than that of the copper is difficult, and it tends to be F < f. In this case, when the F is small but the T is increased, a product of F x T becomes high. On the other hand, when the t is decreased, a product of f x t can be decreased. Thus, (F x T) / (f x t) => 1 may be satisfied. However, if the T is too great, winding the composite around the material to be shielded (electric wire and the like) becomes difficult. If the t is too small, the elongation after fracture of the copper foil becomes extremely small. It is therefore preferable that T and t are within the above-defined range.

### <Ni coating>

On one surface of the copper foil, Ni is coated at a coating amount of 90 to 5000 µg/dm². Conventionally, Ni is plated at a thickness of 0.5 µm or more. However, the present inventors found that when Ni is coated on the surface of the copper foil at a thickness of 0.5 µm or more, the ductility of the copper foil is decreased as in Sn. Then, Ni is coated at a coating amount of 5000 µg/dm² or less. The Ni coating at a coating amount of 90 to 5000 µg/dm² prevents oxidation and corrosion of the surface of the copper foil as well as deterioration of the shielding property. Also, contact resistance between a drain wire and the copper foil is decreased so that the shielding property can be kept. The Ni coating may not completely cover the surface of the copper foil, and a pin hole and the like may be present.

When the coating amount of the Ni coating is less than 90 µg/dm² (which corresponds to the Ni thickness of 1 nm), the oxidation and the corrosion of the surface of the copper foil cannot be prevented, so that the shielding property is deteriorated. Also, the contact resistance between the drain wire and the copper foil is increased, so that the shielding property is degraded.

On the other hand, when the coating amount of the Ni coating exceeds 5000 pg/dm² (which corresponds to the Ni thickness of 56 nm), the ductility of the copper foil (and electromagnetic shielding composite) is decreased and the copper foil is cracked when the electric wire or the cable is bent, so that the shielding property is deteriorated.

The method of coating Ni is not limited. For example, the copper foil is plated with Ni in a known Watt bath, a nickel sulfate bath, a nickel chloride bath, a sulfamate bath and the like.

### <Cr oxide layer>

In harsh usage environments such as an engine compartment of a vehicle, the Ni coating at a coating amount of 5000 µg/dm² or less may not prevent the oxidation and the corrosion of the surface of the copper foil. Therefore, when a Cr oxide layer is formed on the surface of the Ni coating, the oxidation and the corrosion of the surface of the copper foil can be prevented under the harsh environments. Examples of a surface treatment for the Ni coating include a treatment by a silane coupling agent and an application of an organic type antirust. However, these may not be enough for rust prevention.

In addition, the Cr oxide layer prevents a decrease in ductility of the copper foil (and electromagnetic shielding composite) caused by the Ni coating.

The Cr oxide layer can be formed by any known chromate treatments. The presence of the Cr oxide layer can be determined by X-ray photoemission spectroscopy (XPS) to detect Cr or not (Cr peak is shifted by oxidation). The known chromate treatments are not especially limited. For example, the copper foil on which Ni is coated is immersed into a chromate bath (one or two or more of acids such as sulfuric acid, acetic acid, nitric acid, hydrofluoric acid and phosphoric acid are added to chromic acid or chromate containing hexahydric chromium) or the copper foil on which Ni is coated is electrolyzed in the chromate bath.

The thickness of the Cr oxide layer is 5 to 100 µg/dm² based on the Cr weight. The thickness is calculated based on the chromium content by wet analysis.

### <Change in electric resistance>

When the electromagnetic shielding composite is bent or flexed, constriction(s) and crack(s) are produced and the electric resistance is increased. Even if the constriction(s) and crack(s) are invisible, the shielding property is deteriorated. Therefore, an increase in electric resistance is an indicator of the shielding property.

When the electric wire or the cable using the electromagnetic shielding composite is bent, the ductility of the electromagnetic shielding composite should be 15% at minimum. The ductility of the electromagnetic shielding composite can be evaluated by measuring the electric resistance of the electromagnetic shielding composite after the 15% tensile deformation is applied, and comparing the values before and after the tensile deformation.

Specifically, when (R₂ - R₁)/R₁<0.5 where R₁ is the electric resistance of the electromagnetic shielding composite having a length of 50 mm at 20°C and R₂ is the electric resistance of the electromagnetic shielding composite having a length of 50 mm at 20°C after the 15% tensile deformation is applied at room temperature is satisfied, it can be determined that the ductility of the electromagnetic shielding composite is excellent.

The electric resistance of the electromagnetic shielding composite is measured by a four terminal method. Although a sample is extended longer by applying tension, the length of the sample to be used for the measurement of the electric resistance is defined as uniform (50 mm). In other words, if the volume is uniform and the sample is extended uniformly (excluding other factors such as an increase in dislocation), the electric resistance is increased by a decrease in a section area after the 15% tensile deformation is applied. As a result, even if no constriction(s) or crack(s) is produced, the value of (R₂ - R₁)/R₁ is 0.15. On the other hand, it is found that when the constriction(s) or crack(s) is produced and the value of (R₂ - R₁)/R₁ is 0.5 or more, the shielding property is deteriorated.

After the 15% tensile deformation is applied, dislocation density is actually increased even if no constriction(s) or crack(s) is produced, and the aforementioned value exceeds 0.15.

Even if (R₂ - R₁)/R₁ <0.5 after the 15% tensile deformation is applied, the copper foil is oxidized or corroded when the electromagnetic shielding composite is exposed to the harsh environments, e.g., outdoor, for a long period of time. As a result, the electric resistance of the electromagnetic shielding composite is increased and the value of (R₂ - R₁)/R₁ becomes 0.5 or more.

So, as the evaluation to envision that the electromagnetic shielding composite is used under the harsh environments for a long period of time, if (R₃ - R₁)/R₁<0.5 is satisfied as is the case in the above, it can be determined that the ductility of the electromagnetic shielding composite after a long period of use is excellent, where R₃ is the electric resistance of the electromagnetic shielding composite at 20°C after heating at 80°C for 1000 hours and the 15% tensile deformation is applied at room temperature.

The reason why heating at 80°C for 1000 hours is selected as the harsh environment is that an upper temperature limit of common electric wires is 80°C and is measured for 10000 hours. When the values of (R₃ - R₁)/R₁ for 1000 hours and 10000 hours are compared, the results have the same trend. So, 1000 hours are employed.

### <Long term reliability evaluation>

When the contact resistance between the electromagnetic shielding composite (copper foil) and the drain wire is increased, the shielding property is deteriorated. Also when the electromagnetic shielding composite is used for a long period of time or used outside or at high temperature such as an engine compartment of a vehicle, the contact resistance increases due to the diffusion of Ni or oxidation of Cu, and the shielding property is deteriorated.

As an indicator of the long term reliability, the contact resistance of the electromagnetic shielding composite after annealing at 180°C for 500 hours is evaluated at the Ni plated side.

The contact resistance can be measured using an electric contact simulator (for example, CRS-1 manufactured by Yamasaki Seiki Co., Ltd.) with a gold probe, under a contact load of 40 g, at a sliding speed of 1 mm/min and at a sliding distance of 1 mm. When the contact resistance exceeds 5Ω, it is found that the shielding property of the electromagnetic shielding composite is degraded.

### [Example]

### <Production of copper foil composite>

An ingot consists of tough pitch copper or oxygen-free copper was hot-rolled, and surface grinded to remove the oxide. Then the ingot was cold-rolled, annealed, and acid pickled repeatedly to decrease the thickness as shown in Table 1, and finally, annealed to provide a copper foil having workability. The tension upon the cold-rolling and the reduction conditions of the rolled material in a width direction were made uniform so that the copper foil had the uniform composition in the width direction. In the next annealing, a plurality of heaters were used to control the temperature and the temperature of the copper was measured and controlled so that the temperature distribution in the width direction became uniform. Ag or Sn was added to some of the copper ingots in the amount shown in Table 1 to provide the copper foil.

In each of Examples 1 to 7 and Comparative Examples 1 to 2, tough pitch copper was used, and in each of the rests, oxygen-free copper was used.

To the one surface of the above-obtained copper foil, a biaxially-oriented PET (or PI) film (a special order product) shown in Table 1 was adhered using a polyurethane based adhesive agent having a thickness of 3 µm. The copper foil was immersed into a Ni plating bath (a sulfamic acid Ni plating bath having a Ni ion concentration of 1 to 30 g/L), and a Ni was plated on an exposed surface (a surface to which the PET film is not adhered) of the copper foil at a temperature of a plating bath of 25 to 60°C and at a current density of 0.5 to 10 A/dm². The coating amount of the Ni plating was adjusted as shown in Table 1. As to the samples in Comparative Examples 7 and 8, the copper foil was immersed into an Sn plating bath (an Sn ion concentration of 30 g/L) in place of the Ni plating, and Sn was plated on an exposed surface (a surface to which the PET film is not adhered) of the copper foil at a temperature of a plating bath of 40°C and at a current density of 8 A/dm².

Then, the Ni plated one was electrolyzed in a chromate bath (K₂Cr₂O₇: 0.5 to 1.5 g/l, bath temperature: 50°C) at a current density of 1 to 10 A/dm², whereby the chromate treatment was conducted on the Ni plated surface. Each coating amount of the chrome oxide layer by the chromate treatment was adjusted as shown in Table 1. Thus, the electromagnetic shielding composite was produced as described above.

In Examples 5 and 7, the Ni plating and the chromate treatment were conducted on both surfaces of the copper foil, and a film was then adhered to one surface.

The produced electromagnetic shielding composite was cut into strip samples each having a width of 11.5 mm. By the four terminal method, the electric resistance across both ends of the sample having a length of 50 mm was measured at 20°C. Thereafter, the 15% tensile deformation was applied to the sample at room temperature, and the electric resistance across both ends of the sample having a length of 50 mm was measured at 20°C. A part of the sample was heated at 80°C for 1000 hours, and the 15% tensile deformation was further applied thereto at room temperature. And the electric resistance across both ends of the sample having a length of 50 mm was measured at 20°C.

When the sample was curled due to the tension, the sample was fixed, for example, to a resin plate after the tension was applied. When the surface of the sample was oxidized by heating and the electric resistance was not well measured, only a contact part was lightly chemical-polished.

### <Bending property of the composite>

The electromagnetic shielding composite was wrapped around a cable having a diameter of 5 mm or 2.5 mm to produce a longitudinally lapped shielded line. The shielded line was bent one time at ± 180° and a bending radius of 2.5 mm to visually determine the crack(s) in the copper foil composite. The cooper foil composite having no crack(s) was evaluated as "good". The bending property was evaluated before and after the application of a heat load at 80°C for 1000 hours.

Herein the longitudinally lapped shielded line is obtained by wrapping the composite around the cable in an axial direction.

### <Long term reliability evaluation>

The contact resistance of the electromagnetic shielding composite after annealing at 180°C for 500 hours was evaluated as the contact resistance at the Ni plated surface. The contact resistance was measured using an electric contact simulator (for example, CRS-1 manufactured by Yamasaki Seiki Co., Ltd.) with a gold probe, under a contact load of 40 g, at a sliding speed of 1 mm/min and at a sliding distance of 1 mm. When the contact resistance exceeds 5Ω, the shielding property of the electromagnetic shielding composite is degraded.

The results obtained are shown in Table 1.

| | Copper foil | | | Film | | Ni coating | Cr (*µ*g/dm²) | Change in electric resistance | | Bending property | | Long term reliability (Ω) | Copper foil | | Film | | Composite | |
|---|---|---|---|---|---|---|---|---|---|---|---|---|---|---|---|---|---|---|
| | Thickness t (µm) | Added element | | Type | Thickness t (µm) | Coating amount (µ g/dm²) | | (R₂-R₁) /R₁ | (R₃-R₁) /R₁ | Before heat load | After heat load | | elongation after fracture(%) | f (MPa) | F (MPa) | elongation after fracture(%) | (F × T) (f×t) | elongation after fracture(%) |
| | | Type | Amount (wtppm) | | | | | | | | | | | | | | | |
| Example 1 | 8 | Nothing | - | PET | 12 | 100 | 20 | 0.16 | 0.28 | Good | Good | 0.81 | 5.8 | 149 | 127 | 80 | 1.28 | 33 |
| Example 2 | 8 | Nothing | - | PET | 12 | 300 | 20 | 0.15 | 0.22 | Good | Good | 0.46 | 5.8 | 149 | 127 | 80 | 1.28 | 33 |
| Example 3 | 8 | Nothing | - | PET | 12 | 800 | 20 | 0.14 | 0.2 | Good | Good | 0.46 | 5.8 | 149 | 127 | 80 | 1.28 | 31 |
| Example 4 | 8 | Nothing | - | PET | 12 | 1000 | 8 | 0.15 | 0.18 | Good | Good | 0.12 | 5.8 | 149 | 127 | 80 | 1.28 | 30 |
| ExamDle 5 | 8 | Nothing | - | PI | 12 | 5000 | 8 | 0.16 | 0.16 | Good | Good | 0.011 | 5.8 | 149 | 158 | 75 | 1.59 | 28 |
| Example 6 | 10 | Nothing | - | PET | 25 | 800 | 25 | 0.15 | 0.18 | Good | Good | 0.46 | 9.5 | 142 | 130 | 95 | 2.29 | 30 |
| Example 7 | 15 | Nothing | - | PET | 25 | 800 | 30 | 0.15 | 0.22 | Good | Good | 0.48 | 14.3 | 136 | 130 | 95 | 1.59 | 33 |
| Example 8 | 12 | Ag | 150 | PET | 12 | 800 | 10 | 0.16 | 0.21 | Good | Good | 0.48 | 7.0 | 98 | 127 | 80 | 1.30 | 25 |
| Example 9 | 6 | Sn | 1000 | PET | 12 | 800 | 10 | 0.16 | 0.24 | Good | Good | 0.32 | 7.3 | 177 | 127 | 80 | 1.44 | 34 |
| Example 10 | 8 | Nothing | - | PET | 12 | 100 | 10 | ∞ | ∞ | Bad | Bad | 0.48 | 5.8 | 145 | 80 | 155 | 0.83 | 13 |
| Example 1 | 15 | Nothing | - | PET | 12 | 100 | 12 | ∞ | ∞ | Bad | Bad | 0.48 | 14.3 | 145 | 80 | 155 | 0.44 | 14 |
| Comparative Example 1 | 8 | Nothing | - | PET | 12 | - | 0 | 0.14 | ∞ | Good | Bad | 5< | 5.8 | 149 | 127 | 80 | 1.28 | 34 |
| Comparative Example 2 | 8 | Nothing | - | PET | 12 | - | 20 | 0.15 | ∞ | Good | Bad | 5< | 5.8 | 149 | 127 | 80 | 1.28 | 32 |
| Comparative Example 3 | 8 | Nothing | - | PET | 12 | 800 | 0 | 0.32 | ∞ | Good | Bad | 5< | 5.8 | 149 | 127 | 80 | 1.28 | 30 |
| Comparative Example 4 | 8 | Nothing | - | PET | 12 | 40 | 20 | 0.18 | 0.83 | Good | Bad | 5< | 5.8 | 149 | 127 | 80 | 1.28 | 33 |
| Comparative Example 5 | 8 | Nothing | - | PET | 12 | 10000 | 20 | 0.70 | ∞ | Bad | Bad | 0.006 | 5.8 | 149 | 127 | 80 | 1.28 | 17 |
| Comparative Example 6 | 8 | Nothing | - | PET | 12 | 10000 | 0 | ∞ | ∞ | Bad | Bad | 0.025 | 5.8 | 149 | 127 | 80 | 1.28 | 17 |
| Comparative Example 7 | 8 | Nothing | - | PET | 12 | 1000(Sn) | 0 | 0.16 | ∞ | Good | Bad | 5< | 5.8 | 149 | 127 | 80 | 1.28 | 18 |
| Comparative Example 8 | 8 | Nothing | - | PET | 12 | 150000(Sn) | 80 | ∞ | ∞ | Bad | Bad | 0.004 | 5.8 | 149 | 127 | 80 | 1.28 | 13 |
| Comparative Example 9 | 8 | Nothing | - | PET | 12 | 100 | 20 | ∞ | ∞ | Bad | Bad | 0.48 | 5.8 | 145 | 80 | 155 | 0.83 | 13 |
| Comparative Example 10 | 15 | Nothing | - | PET | 12 | 100 | 20 | ∞ | ∞ | Bad | Bad | 0.48 | 14.3 | 145 | 80 | 155 | 0.44 | 14 |

As apparent from Table 1, in each of Examples 1 to 9, a change in the electric resistance after the 15% tensile deformation, and a change in the electric resistance after the 15% tensile deformation and after heating at 80°C for 1000 hours are both less than 0.5, the ductility of the copper foil (and the electromagnetic shielding composite) is not decreased, the crack(s) in the copper foil and the deterioration of the shielding property can be prevented. In addition, the bending property is good before and after the heat load is applied, and the long term reliability is excellent.

In each of Examples 10 and 11, since a commercially available biaxially-oriented PET film having F=80 MPa was used as the film, the strength of the film is significantly low (F/f is smaller than 0.7) as compared with that of the copper foil and (F x T) / (f x t) < 1. As a result, the stress applied to the copper foil is greater than the stress applied to the film under tension, and the copper foil was broken by tension load. Also, the bending property is degraded before and after the heat load is applied. However, in Examples 10 and 11, the long term reliability is excellent. This may be because the Ni coating and the Cr oxide layer prevents the oxidation of the copper foil due to the heat.

On the other hand, in each of Comparative Examples 1 and 2 where Ni was not coated on one surface (opposite surface of the film) of the copper foil, a change in the electric resistance after the 15% tensile deformation and after heating exceeds 0.5, the bending property is degraded after the heat load, and the long term reliability is poor. It is considered that heating causes oxidation and corrosion of the surface of the copper foil.

In Comparative Example 3 where Ni was coated but Cr oxide layer was not formed on one surface (opposite surface of the film) of the copper foil, a change in the electric resistance after the 15% tensile deformation and after heating exceeds 0.5, the bending property is deteriorated after the heat load, and the long term reliability is poor. It is considered that there is no Cr oxide layer and heating causes oxidation and corrosion of the surface of the copper foil.

In Comparative Example 4 where the Ni coating amount was less than 90 µg/dm² on one surface (opposite surface of the film) of the copper foil, a change in the electric resistance after the 15% tensile deformation and after heating exceeds 0.5, the bending property is deteriorated after the heat load, and the long term reliability is poor. It is considered that the Ni coating amount is small and heating causes oxidation and corrosion of the surface of the copper foil.

In Comparative Example 5 where the Ni coating amount exceeded 5000 µg/dm² on one surface (opposite surface of the film) of the copper foil, a change in the electric resistance after the 15% tensile deformation and after heating exceeds 0.5, and the bending property is deteriorated before the heat load is applied. It is considered that the Ni coating amount is too much and Ni is diffused to the copper foil to decrease the ductility of the copper foil and produce the crack(s) in the copper foil.

In Comparative Example 6 where the Ni coating amount exceeded 5000 µg/dm² on one surface (opposite surface of the film) of the copper foil and no Cr oxide layer was formed, a change in the electric resistance after the 15% tensile deformation exceeds 0.5. It is considered that since there is no Cr oxide layer, Ni is diffused rapidly to the copper foil at the beginning before the heat is applied, the ductility of the copper foil is then decreased and the crack(s) is produced on the copper foil.

In Comparative Examples 7 and 8 where Sn was coated on one surface (opposite surface of the film) of the copper foil, a change in the electric resistance after the 15% tensile deformation and after heating exceeds 0.5, the bending property is deteriorated after the heat load is applied, and the long term reliability is poor. It is considered that heating causes diffusion of Sn into the copper foil to decrease the ductility of the copper foil and produce the crack(s) in the copper foil. In particular, in Comparative Example 8, the coating amount of Sn is too high and Sn is rapidly diffused into the copper foil at the beginning before the heat is applied, so that the ductility of the copper foil is decreased and the crack(s) in the copper foil is produced.

## Claims

1. An electromagnetic shielding composite, comprising a copper foil, **characterized in that** the copper foil has a thickness of 5 to 15 µm, a Ni coating on one surface of the copper foil at a coating amount of 90 to 5000 µg/dm², a Cr oxide layer formed on the surface of the Ni coating at 5 to 100 µg/dm² based on the Cr mass, and a resin layer laminated on the opposite surface of the copper foil, and the copper foil has elongation after fracture of 5% or more, and (F x T) / (f x t) => 1 is satisfied where t is the thickness of the copper foil, f is a stress of the copper foil at tensile strain of 4%, T is the thickness of the resin layer, and F is a stress of the resin layer at tensile strain of 4%.

2. An electromagnetic shielding composite, comprising a copper foil, **characterized in that** the copper foil has a thickness of 5 to 15 µm, Ni coatings on both surfaces of the copper foil at a coating amount of 90 to 5000 µg/dm² respectively, Cr oxide layers formed on the surfaces of the Ni coatings at 5 to 100 µg/dm² based on the Cr mass, and a resin layer laminated on one surface of the Cr oxide layer on the copper foil, and the copper foil has elongation after fracture of 5% or more, and (F x T) / (f x t) => 1 is satisfied where t is the thickness of the copper foil, f is a stress of the copper foil at tensile strain of 4%, T is the thickness of the resin layer, and F is a stress of the resin layer at tensile strain of 4%.

3. The electromagnetic shielding composite according to Claim 1 or 2, wherein the thickness of the resin layer is 7 to 25 µm, and F => 100 MPa is satisfied.

4. The electromagnetic shielding composite according to any one of Claims 1 to 3, wherein (R₂ - R₁)/R₁<0.5 is satisfied where R₁ is the electric resistance of the electromagnetic shielding composite having a length of 50 mm at 20°C and R₂ is the electric resistance of the electromagnetic shielding composite having a length of 50 mm at 20°C after 15% tensile deformation is applied at room temperature.

5. The electromagnetic shielding composite according to any one of Claims 1 to 4, wherein (R₃ - R₁)/R₁<0.5 is satisfied where R₁ is the electric resistance of the electromagnetic shielding composite having a length of 50 mm at 20°C and R₃ is the electric resistance of the electromagnetic shielding composite having a length of 50 mm at 20°C after heating at 80°C for 1000 hours and 15% tensile deformation is applied at room temperature.

6. The electromagnetic shielding composite according to any one of Claims 1 to 5, wherein the copper foil contains Sn and/or Ag at a total content of 200 to 2000 mass ppm.

## Patentansprüche

1. Eine Kupferfolie umfassendes Verbundmaterial zur elektromagnetischen Abschirmung, **dadurch gekennzeichnet, dass** die Kupferfolie eine Dicke von 5 bis 15 µm, eine Ni-Beschichtung auf einer Oberfläche der Kupferfolie mit einer Beschichtungsmenge von 90 bis 5000 µg/dm², eine Cr-Oxid-Schicht, welche auf der Oberfläche der Ni-Beschichtung mit 5 bis 100 µg/dm² basierend auf der Cr-Masse ausgebildet ist, und eine auf der entgegengesetzten Oberfläche der Kupferfolie aufgebrachte Harzschicht besitzt, und die Kupferfolie eine Bruchdehnung von 5 % oder mehr besitzt, und (F x T)/(f x t) ≥ 1 erfüllt ist, wobei t die Dicke der Kupferfolie ist, f eine Spannung der Kupferfolie bei Zugbelastung von 4 % ist, T die Dicke der Harzschicht ist, und F eine Spannung der Harzschicht bei Zugbelastung von 4 % ist.

2. Eine Kupferfolie umfassendes Verbundmaterial zur elektromagnetischen Abschirmung, **dadurch gekennzeichnet, dass** die Kupferfolie eine Dicke von 5 bis 15 µm, Ni-Beschichtungen auf beiden Oberflächen der Kupferfolie mit einer Beschichtungsmenge von jeweils 90 bis 5000 µg/dm², Cr-Oxid-Schichten, welche auf den Oberflächen der Ni-Beschichtung mit 5 bis 100 µg/dm² basierend auf der Cr-Masse ausgebildet sind, und eine auf einer Oberfläche der Kupferfolie aufgebrachte Harzschicht besitzt, und die Kupferfolie eine Bruchdehnung von 5 % oder mehr besitzt, und (F x T)/(f x t) ≥ 1 erfüllt ist, wobei t die Dicke der Kupferfolie ist, f eine Spannung der Kupferfolie bei Zugbelastung von 4 % ist, T die Dicke der Harzschicht ist, und F eine Spannung der Harzschicht bei Zugbelastung von 4 % ist.

3. Verbundmaterial zur elektromagnetischen Abschirmung gemäß Anspruch 1 oder 2, wobei die Dicke der Harzschicht 7 bis 25 µm ist, und F ≥ 100 MPa erfüllt ist.

4. Verbundmaterial zur elektromagnetischen Abschirmung gemäß einem der Ansprüche 1 bis 3, wobei (R₂ - R₁) / R₁ < 0,5 erfüllt ist, wobei R₁ der elektrische Widerstand des Verbundmaterials zur elektromagnetischen Abschirmung bei einer Länge von 50 mm bei 20 °C ist und R₂ der elektrische Widerstand des Verbundmaterials zur elektromagnetischen Abschirmung bei einer Länge von 50 mm bei 20 °C nach Anwendung von 15 % Zugverformung bei Raumtemperatur ist.

5. Verbundmaterial zur elektromagnetischen Abschirmung gemäß einem der Ansprüche 1 bis 4, wobei (R₃ - R₁) / R₁ < 0,5 erfüllt ist, wobei R₁ der elektrische Widerstand des Verbundmaterials zur elektromagnetischen Abschirmung bei einer Länge von 50 mm bei 20 °C ist und R₃ der elektrische Widerstand des Verbundmaterials zur elektromagnetischen Abschirmung bei einer Länge von 50 mm bei 20 °C nach Erhitzen bei 80°C für 100,0 Stunden und Anwendung von 15 % Zugverformung bei Raumtemperatur ist.

6. Verbundmaterial zur elektromagnetischen Abschirmung gemäß einem der Ansprüche 1 bis 5, wobei die Kupferfolie Sn und/oder Ag mit einem Gesamtgehalt von 200-2000 Massen-ppm enthält.

## Revendications

1. Composite de blindage électromagnétique comprenant une feuille de cuivre, **caractérisé en ce que** la feuille de cuivre a une épaisseur de 5 à 15 µm, un revêtement de Ni sur une surface de la feuille de cuivre selon une quantité de revêtement de 90 à 5000 µg/dm², une couche d'oxyde de Cr formée sur la surface du revêtement de Ni à 5 à 100 µg/dm² en fonction de la masse de Cr, et une couche de résine stratifiée sur la surface opposée de la feuille de cuivre, la feuille de cuivre a une élongation après fracture de 5 % ou plus, et (F x T) / (f x t) => 1 est satisfait où t est l'épaisseur de la feuille de cuivre, f est une contrainte de la feuille de cuivre à un allongement en traction de 4 %, T est l'épaisseur de la couche de résine et F est une contrainte de la couche de résine à un allongement en traction de 4 %.

2. Composite de blindage électromagnétique comprenant une feuille de cuivre, **caractérisé en ce que** la feuille de cuivre a une épaisseur de 5 à 15 µm, des revêtements de Ni sur les deux surfaces de la feuille de cuivre selon une quantité de revêtement de 90 à 5000 µg/dm² respectivement, des couches d'oxyde de Cr formées sur les surfaces des revêtements de Ni à 5 à 100 µg/dm² en fonction de la masse de Cr, et une couche de résine stratifiée sur une surface de la couche d'oxyde de Cr sur la feuille de cuivre, et la feuille de cuivre a une élongation après fracture de 5 % ou plus, et (F x T) / (f x t) => 1 est satisfait où t est l'épaisseur de la feuille de cuivre, f est une contrainte de la feuille de cuivre à un allongement en traction de 4 %, T est l'épaisseur de la couche de résine et F est une contrainte de la couche de résine à un allongement en traction de 4 %.

3. Composite de blindage électromagnétique selon la revendication 1 ou 2, dans lequel l'épaisseur de la couche de résine est de 7 à 25 µm et F => 100 MPa est satisfait.

4. Composite de blindage électromagnétique selon l'une quelconque des revendications 1 à 3, dans lequel (R₂ - R₁)/R₁ < 0,5 est satisfait où R₁ est la résistance électrique du composite de blindage électromagnétique ayant une longueur de 50 mm à 20 °C et R₂ est la résistance électrique du composite de blindage électromagnétique ayant une longueur de 50 mm à 20 °C après l'application d'une déformation à la traction de 15% à température ambiante.

5. Composite de blindage électromagnétique selon l'une quelconque des revendications 1 à 4, dans lequel (R₃ - R₁)/R₁ < 0,5 est satisfait où R₁ est la résistance électrique du composite de blindage électromagnétique ayant une longueur de 50 mm à 20 °C et R₃ est la résistance électrique du composite de blindage électromagnétique ayant une longueur de 50 mm à 20 °C après le chauffage à 80 °C pendant 1000 heures et l'application d'une déformation à la traction de 15 % à température ambiante.

6. Composite de blindage électromagnétique selon l'une quelconque des revendications 1 à 5, dans lequel la feuille de cuivre contient du Sn et/ou de l'Ag selon une teneur totale de 200 à 2000 ppm en masse.
